# DEMANDE DE BREVET EUROPEEN

(11) **EP 4 704 530 A1**
(43) Date de publication de la demande: **04.03.2026**
(21) Numéro de dépôt: 25199156.8
(22) Date de dépôt: 29.08.2025
(51) Int. Cl.: H10H 29/34, H10H 29/851, H10K 59/35

(54) **DISPOSITIF OPTOELECTRONIQUE EMISSIF A TAUX DE CONVERSION DE COULEUR AMELIORE ET PROCEDE DE FABRICATION**

(30) Priorité: 30.08.2024 FR 2409293
(71) Demandeur: Commissariat à l'Energie Atomique et aux Energies Alternatives, 75015 Paris (FR)
(72) Inventeur: ALTAZIN, Stéphane, 38054 Grenoble Cedex 09 (FR); MIRALLES, Bastien, 38054 Grenoble Cedex 09 (FR); MICHIT, Nicolas, 38054 Grenoble Cedex 09 (FR); BALLOT, Clément, 38054 Grenoble Cedex 09 (FR)
(74) Mandataire: Santarelli

(57) **Abrégé**

L'invention porte sur un dispositif optoélectronique à conversion de lumière, comportant des diodes électroluminescentes et des plots de conversion (40). Des portions espaceur (23), conducteurs et transparents, sont situées entre la portion réflectrice (22) et la portion conductrice inférieure (31) des pixels lumineux à conversion (Px_{ac}) uniquement ou des pixels lumineux sans conversion (Px_{sc}) uniquement. De plus, l'épaisseur (e_{31.opt}) des portions conductrices inférieures (31) et l'épaisseur (e_{23.opt}) des portions espaceur (23) sont prédéfinies de manière à maximiser : dans les pixels lumineux sans conversion (Px_{sc}), un taux d'extraction hors de la diode électroluminescente de la lumière émise ; et dans les pixels lumineux à conversion (Px_{ac}), un taux de couplage de la lumière émise par la portion active (32) avec des modes optiques supportés dans la portion de conversion (40).

## Description

### DOMAINE TECHNIQUE

Le domaine de l'invention est celui des dispositifs optoélectroniques comportant une matrice de pixels lumineux à conversion de couleur. L'invention trouve une application notamment dans les écrans d'affichage et les projecteurs d'images.

### ÉTAT DE LA TECHNIQUE ANTÉRIEURE

Il existe des dispositifs optoélectroniques comportant une matrice de pixels lumineux formés de diodes électroluminescentes identiques entre elles, où certains pixels comportent des portions de conversion de couleur. On obtient ainsi une matrice de pixels lumineux de différentes couleurs ; de tels dispositifs optoélectroniques peuvent alors former des écrans d'affichage ou des systèmes de projection d'images.

Dans un tel dispositif optoélectronique, chaque pixel lumineux à conversion de couleur comporte une ou plusieurs diodes électroluminescentes associées à une portion de conversion de couleur. Dans le but d'obtenir des pixels lumineux adaptés à émettre des rayonnements lumineux de différentes couleurs, par exemple bleu, vert ou rouge, les diodes électroluminescentes peuvent être adaptées à émettre toute une même lumière, par exemple une lumière bleue, et les pixels verts et rouges comportent des portions de conversion de lumière adaptées à absorber au moins en partie la lumière bleue incidente, et à émettre en réponse une lumière verte ou une lumière rouge.

Les diodes électroluminescentes sont donc de préférence identiques entre elles, et émettent un rayonnement lumineux de même longueur d'onde. Elles peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une face avant au travers de laquelle est transmis le rayonnement lumineux généré. Par ailleurs, les diodes électroluminescentes peuvent comporter une électrode réflectrice du côté de la face arrière, et une électrode transparente du côté de la face avant.

Les portions de conversion de lumière peuvent être formées d'une matrice liante comportant des particules d'un matériau photoluminescent tel que, notamment, le grenat d'yttrium et d'aluminium (YAG, pour *Yttrium Aluminium Garnet,* en anglais) activé par l'ion cérium YAG:Ce. Les particules photoluminescentes peuvent également être des boîtes quantiques (*quantum dots,* en anglais), c'est-à-dire sous la forme de nanocristaux semiconducteurs dont le confinement quantique est sensiblement tridimensionnel.

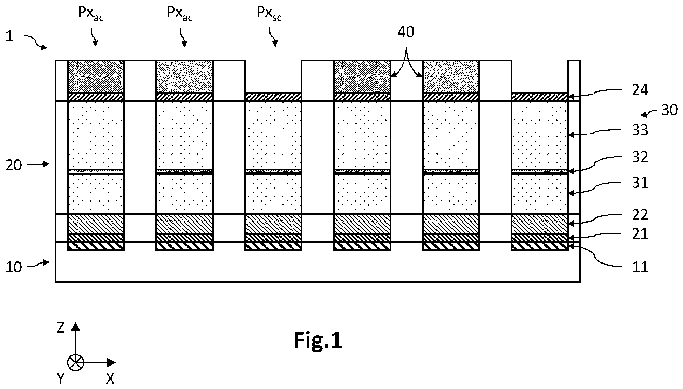

La figure 1 est une vue schématique et partielle, en coupe transversale, d'un dispositif optoélectronique 1 selon un exemple de l'art antérieur. Il comporte ici une puce de commande 10 dont une face avant comporte des portions conductrices 11 pour polariser et commander les diodes électroluminescentes. Il comporte une puce optoélectronique 20 qui repose sur la puce de commande 10 et est connectée électriquement à celle-ci. Elle comporte la matrice de diodes électroluminescentes. Chaque diode électroluminescente comporte une structure diode 30 formée d'un empilement semiconducteur de deux portions semiconductrices dopées 31, 33 entre lesquelles se situe une portion active 32. Il repose sur une électrode inférieure réflectrice, formée ici d'une portion de contact électrique 21 et d'une portion réflectrice 22. Enfin, certaines diodes sont recouvertes par des portions de conversion de lumière 40 et définissent des pixels lumineux à conversion de couleur Px_{ac}, alors que les diodes non recouvertes par les portions de conversion 40 définissent des pixels lumineux sans conversion de couleur Px_{sc}.

Il existe un besoin d'améliorer le taux de conversion de couleur. Pour cela, une solution peut consister à augmenter l'épaisseur des portions de conversion. Cependant, cela peut induire des difficultés technologiques, en particulier lorsque le pas pixel est petit.

### EXPOSÉ DE L'INVENTION

L'invention a pour objectif de remédier au moins en partie aux inconvénients de l'art antérieur, et plus particulièrement de proposer un dispositif optoélectronique, et son procédé de fabrication, dont le taux de conversion de couleur est amélioré dans les pixels lumineux avec conversion Px_{ac}, tout en maintenant de bonnes performances dans les pixels lumineux sans conversion Px_{sc}.

Pour cela, l'objet de l'invention est un dispositif optoélectronique à conversion de lumière, comportant :
∘ une matrice de diodes électroluminescentes, chaque diode électroluminescente comportant dans cet ordre : une électrode inférieure réflectrice formée d'une portion de contact puis d'une portion réflectrice ; une structure diode formée d'une portion conductrice inférieure d'une même épaisseur pour toutes les diodes de la matrice, d'une portion active d'émission de lumière, puis d'une portion conductrice supérieure ; et une électrode supérieure ;
∘ des plots de conversion de couleur, recouvrant certaines diodes électroluminescentes de la matrice, et définissant des pixels lumineux à conversion de couleur ; les diodes électroluminescentes non recouvertes par des plots de conversion définissant des pixels lumineux sans conversion de couleur.

Selon l'invention, le dispositif optoélectronique comporte des portions espaceur, réalisées en un matériau électriquement conducteur et transparent à la lumière émise, et situées entre la portion réflectrice et la portion conductrice inférieure des pixels lumineux à conversion uniquement ou des pixels lumineux sans conversion uniquement.

De plus, l'épaisseur des portions conductrices inférieures et l'épaisseur des portions espaceur sont prédéfinies de sorte que :
∘ chaque portion active des pixels lumineux sans conversion est espacée de la portion réflectrice d'une même distance optimale h_{sc.opt} maximisant, dans les pixels lumineux sans conversion, un paramètre représentatif d'un taux d'extraction de la lumière émise par la portion active hors de la diode électroluminescente ; et
∘ chaque portion active des pixels lumineux à conversion est espacée de la portion réflectrice d'une même distance optimale h_{ac.opt} maximisant, dans les pixels lumineux à conversion, un paramètre représentatif d'un taux de couplage de la lumière émise par la portion active avec des modes optiques supportés dans la portion de conversion.

Certains aspects préférés mais non limitatifs de ce dispositif optoélectronique sont les suivants.

Les portions réflectrices de la matrice de diodes peuvent présenter une même épaisseur.

Les portions de contact peuvent présenter une épaisseur différente entre les pixels lumineux à conversion et les pixels lumineux sans conversion, et peuvent présenter une face inférieure coplanaire d'une portion de contact à l'autre.

Les portions conductrices inférieures peuvent présenter une face inférieure coplanaire d'une portion conductrice inférieure à l'autre.

Les portions actives peuvent être coplanaires.

La portion conductrice inférieure peut être réalisée en au moins un matériau semiconducteur.

La portion conductrice inférieure peut comporter une première sous-couche en au moins un matériau semiconducteur, située du côté de la portion active, et une deuxième sous-couche en un matériau électriquement conducteur et transparent à la lumière émise, située du côté de la portion réflectrice.

Les diodes électroluminescentes peuvent être inorganiques ou organiques.

L'invention porte également sur un procédé de fabrication du dispositif optoélectronique selon l'une quelconque des caractéristiques précédentes, comportant les étapes suivantes :
∘ détermination d'une épaisseur optimale e_{31.opt} des portions conductrices inférieures, à partir d'une fonction prédéterminée exprimant :
   - selon une première possibilité : une évolution du paramètre représentatif du taux d'extraction, en fonction de l'épaisseur e₃₁ de la portion inférieure conductrice, dans les pixels lumineux sans conversion, la valeur optimale e_{31.opt} maximisant le paramètre représentatif du taux d'extraction, de sorte que l'on obtient la distance h_{sc.opt} ; ou
   - selon une deuxième possibilité : une évolution du paramètre représentatif du taux de couplage de la lumière émise par la portion active avec des modes optiques supportés dans la portion de conversion, dans les pixels lumineux à conversion, la valeur optimale e_{31.opt} maximisant le paramètre représentatif du taux de couplage, de sorte que l'on obtient la distance h_{ac.opt} ;
∘ détermination d'une épaisseur optimale e_{23.opt} des portions espaceur, compte tenu d'épaisseur optimale e_{31.opt} prédéterminée, à partir d'une fonction prédéterminée exprimant :
   - selon la première possibilité : une évolution du paramètre représentatif du taux de couplage, en fonction de l'épaisseur e₂₃ de la portion espaceur, les portions espaceur étant situées uniquement dans les pixels lumineux à conversion, l'épaisseur optimale e_{23.opt} maximisant le paramètre représentatif du taux de couplage, de sorte que l'on obtient la distance h_{ac.opt} ;
   - selon la deuxième possibilité : une évolution du paramètre représentatif du taux d'extraction, en fonction de l'épaisseur e₂₃ de la portion espaceur, les portions espaceur étant situées uniquement dans les pixels lumineux sans conversion, l'épaisseur optimale e_{23.opt} maximisant le paramètre représentatif du taux d'extraction, de sorte que l'on obtient la distance h_{sc.opt} ;
∘ réalisation de la matrice de diodes électroluminescentes, de sorte que : les portions conductrices inférieures de la matrice de diodes présentent la même épaisseur optimale e_{31.opt} déterminée; et les portions espaceur présentent la même épaisseur optimale e_{23.opt} déterminée.

Lors de l'étape de détermination de l'épaisseur optimale e_{31.opt} et selon la deuxième possibilité, la valeur optimale e_{31.opt} peut être déterminée de manière à maximiser le paramètre représentatif du taux de couplage et à minimiser un paramètre représentatif d'un deuxième taux de couplage de la lumière émise par la portion active avec des modes optiques supportés dans la portion de conversion et pouvant être extraits hors de la diode.

Lors de l'étape de détermination de l'épaisseur optimale e_{23.opt} et selon la première possibilité, la valeur optimale e_{23.opt} peut être déterminée de manière à maximiser le paramètre représentatif du taux de couplage et à minimiser un paramètre représentatif d'un deuxième taux de couplage de la lumière émise par la portion active avec des modes optiques supportés dans la portion de conversion et pouvant être extraits hors de la diode.

L'étape de réalisation de la matrice de diodes peut comporter les étapes suivantes :
∘ réalisation d'un empilement formé des portions conductrices supérieures, des portions actives, et des portions conductrices inférieures ayant l'épaisseur optimale e_{31.opt} ;
∘ réalisation des portions espaceur, ayant l'épaisseur optimale e_{23.opt}, sur les portions conductrices inférieures des pixels lumineux à conversion dans la première possibilité ou dans les pixels lumineux sans conversion selon la deuxième possibilité ;
∘ réalisation des portions réflectrices puis des portions de contact.

Le procédé peut comporter les étapes suivantes :
∘ à la suite de l'étape de réalisation de la matrice de diodes, report de la structure obtenue sur une puce de commande ;
∘ réalisation des électrodes supérieures sur les portions conductrices supérieures ;
∘ réalisation des portions de conversion.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1, déjà décrite, est une vue schématique et partielle, en coupe transversale, d'un dispositif optoélectronique à matrice de diodes électroluminescentes et à conversion de couleur, selon un exemple de l'art antérieur ;
la figure 2A est une vue schématique et partielle, en coupe transversale, d'un dispositif optoélectronique selon un premier mode de réalisation où les portions espaceur sont situées uniquement dans les pixels lumineux à conversion de couleur ;
la figure 2B est une vue schématique et partielle, en coupe transversale, d'un dispositif optoélectronique selon un deuxième mode de réalisation où les portions espaceur sont situées uniquement dans les pixels lumineux sans conversion de couleur ;
la figure 3A est une vue schématique et partielle, en coupe transversale, d'un pixel lumineux sans conversion de couleur d'un dispositif optoélectronique selon le premier mode de réalisation similaire à celui de la fig.2A ;
la figure 3B illustre une variation, en fonction de l'épaisseur de la portion conductrice inférieure de la diode électroluminescente de la fig.3A, de la répartition de la puissance du rayonnement émis par la portion active de la diode et dissipé dans différents modes optiques associés au pixel lumineux ;
la figure 4A est une vue schématique et partielle, en coupe transversale, d'un pixel lumineux à conversion de couleur d'un dispositif optoélectronique selon le premier mode de réalisation similaire à celui de la fig.2A ;
la figure 4B illustre une variation, en fonction de l'épaisseur de la portion espaceur de la diode électroluminescente de la fig.4A, de la répartition de la puissance du rayonnement émis par la portion active de la diode et dissipé dans différents modes optiques associés au pixel lumineux ;
les figures 5A à 5H illustrent différentes étapes d'un procédé de fabrication d'un dispositif optoélectronique selon le premier mode de réalisation similaire à celui de la fig.2A.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif optoélectronique à conversion de couleur et sur son procédé de fabrication. Le dispositif optoélectronique comporte une matrice de diodes électroluminescentes, dont au moins une partie est recouverte par des portions de conversion de couleur, de manière à former une matrice de pixels lumineux de différentes couleurs. Le dispositif optoélectronique peut être, par exemple, un écran d'affichage ou un projecteur d'image. Les diodes électroluminescentes peuvent être des diodes de type inorganique (LED) ou de type organique (OLED).

Comme détaillé par la suite, les diodes électroluminescentes sont dimensionnées, en termes de distance entre la portion active et la portion réflectrice sous-jacente, de manière à maximiser, dans les pixels lumineux sans conversion de couleur Px_{sc}, le taux d'extraction de la lumière hors de la diode, et dans les pixels lumineux à conversion de couleur Px_{ac}, le taux de couplage de la lumière dans des modes optiques supportés par les portions de conversion (optimisant ainsi le taux d'absorption par les portions de conversion, et donc le taux de conversion).

Pour cela, on dimensionne d'une part l'épaisseur e₃₁ des portions conductrices inférieures des diodes électroluminescentes (qui peuvent être, par exemple, une couche semiconductrice dopée dans le cas des LED ou une couche de transport de porteurs de charge dans le cas des OLED), et on dimensionne d'autre part l'épaisseur e₂₃ de portions espaceur, lesquelles sont situées entre une portion réflectrice de l'électrode inférieure réflectrice et la portion conductrice inférieure de la structure diode. Ces portions espaceur sont présentes soit dans les pixels lumineux à conversion Px_{ac} uniquement (premier mode de réalisation), soit dans les pixels lumineux sans conversion Px_{sc} uniquement (deuxième mode de réalisation).

Ainsi, chaque portion active des pixels lumineux sans conversion Px_{sc} est espacée de la portion réflectrice d'une même distance h_{sc.opt} prédéfinie maximisant, dans les pixels lumineux sans conversion Px_{sc}, l'extraction de la lumière émise par la portion active hors de la diode électroluminescente. De plus, chaque portion active des pixels lumineux à conversion Px_{ac} est espacée de la portion réflectrice d'une même distance h_{ac.opt} prédéfinie maximisant, dans les pixels lumineux à conversion Px_{ac}, le couplage de la lumière émise par la portion active avec des modes optiques supportés dans la portion de conversion.

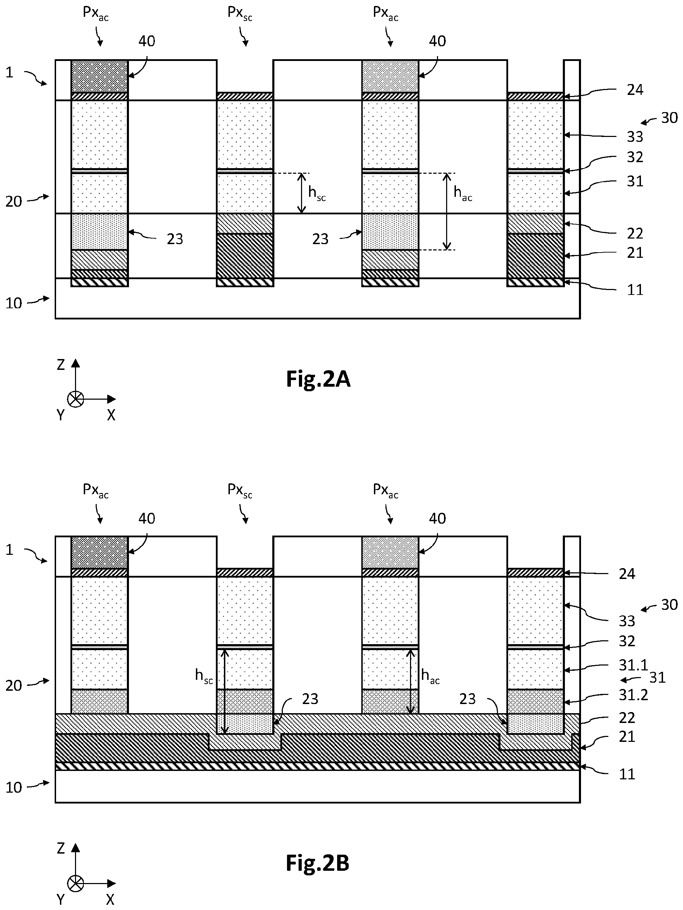

La figure 2A est une vue schématique et partielle, en coupe transversale, d'un dispositif optoélectronique selon le premier mode de réalisation où les portions espaceur 23 sont situées uniquement dans les pixels lumineux à conversion de couleur Px_{ac}, et la figure 2B est une vue schématique et partielle, en coupe transversale, d'un dispositif optoélectronique selon le deuxième mode de réalisation où les portions espaceur 23 sont situées uniquement dans les pixels lumineux sans conversion de couleur Px_{sc}.

Dans ces exemples, le dispositif optoélectronique comporte une matrice de pixels lumineux de type RVB (rouge, vert, bleu). Chaque pixel est formé d'au moins une diode électroluminescente (ici une diode par pixel). D'autres types de pixels lumineux sont possibles, par exemple de type RGB-IR (*Red, Green, Blue, InfraRed,* en anglais).

On définit ici et pour la suite de la description un repère direct tridimensionnel orthogonal XYZ, où les axes X et Y forment un plan principal dans lequel s'étend la matrice de diodes, et où l'axe Z est orienté de la puce de commande en direction de la face avant du dispositif optoélectronique. Dans la suite de la description, les termes « inférieur » et « supérieur » s'entendent comme étant relatifs à un positionnement croissant lorsqu'on s'éloigne de la puce de commande suivant la direction +Z.

Le dispositif optoélectronique 1 peut comporter une puce de commande 10, à laquelle la puce optoélectronique 20 est assemblée et connectée électriquement au niveau de sa face arrière. La puce de commande 10 peut assurer une fonction de support mécanique de la puce optoélectronique 20, et participe à polariser électriquement la matrice de diodes. Il peut comporter un circuit de commande de type CMOS, et présente des portions de connexion électrique 11 qui affleurent sa face supérieure et viennent au contact des électrodes inférieures des diodes, et ici au contact des portions de contact 21. Les portions de connexion électrique 11 sont ici distinctes d'une portion à l'autre. En variante (cf. la fig.2B), il peut s'agir d'une même couche de connexion électrique (notée également 11) : dans ce cas, les électrodes supérieures 24 sont distinctes les unes des autres de manière à pouvoir activer les diodes de manière sélective.

Le dispositif optoélectronique 1 comporte une puce optoélectronique 20, laquelle est formée de la matrice de diodes électroluminescentes et des portions de conversion de lumière 40.

La matrice de diodes électroluminescentes présente une face arrière, par laquelle elle est assemblée et connectée à la puce de commande 10, et une face avant, opposée à la face arrière, par laquelle la lumière émise par les portions actives 32 est transmise hors de la diode. La lumière est alors transmise dans l'environnement de la diode, par exemple dans l'air, dans le cas des pixels lumineux sans conversion Px_{sc}, ou est transmise dans les portions de conversion 40 dans le cas des pixels lumineux à conversion Px_{ac}.

D'une manière générale, les diodes électroluminescentes sont formées d'un empilement, dans cet ordre :
- d'une électrode inférieure réflectrice 21, 22 ;
- d'une structure diode 30 formée d'une portion conductrice inférieure 31, d'une portion active 32 d'émission de lumière, puis d'une portion conductrice supérieure 33 ; et
- d'une électrode supérieure 24.

Dans la suite de la description, l'électrode supérieure 24 est transparente et recouvre de préférence entièrement la face supérieure de la portion conductrice supérieure 33. En variante, elle peut être réalisée en un matériau opaque et peut ne recouvrir qu'une surface latérale de la face supérieure de la portion 33 tout en laissant une surface centrale non recouverte.

Comme détaillé plus loin, dans ce premier mode de réalisation, les diodes des seuls pixels lumineux à conversion Px_{ac} comportent une portion espaceur 23 qui permet d'ajuster la distance h_{ac} entre la portion active 32 et la portion réflectrice 22 sous-jacente. Les diodes des pixels lumineux sans conversion Px_{sc} ne comportent pas de telles portions espaceur 23.

De préférence, les diodes sont structurellement identiques, de sorte que le rayonnement lumineux émis est identique d'une diode à l'autre en termes de longueur d'onde. Dans cet exemple, les diodes sont adaptées à émettre un rayonnement lumineux dans le bleu, c'est-à-dire dont le spectre d'émission présente un pic d'intensité à une longueur d'onde comprise entre 440nm et 490nm environ.

Dans cet exemple, les diodes sont de type inorganique (LED). Les portions conductrices inférieure 31 et supérieure 33 sont ici des portions semiconductrices dopées selon des types de conductivité opposés. A titre d'exemple, la portion conductrice inférieure 31 peut être dopée de type p, et la portion conductrice supérieure 33 est alors dopée de type n. Cet empilement semiconducteur peut être réalisé à partir d'un même composé semiconducteur, par exemple à base d'un composé III-V tel que du GaN, InGaN, AlGaN. Dans cet exemple, la portion conductrice inférieure 31 est en p-GaN et la portion conductrice supérieure 33 est en n-GaN. La portion active 32 d'où est émis le rayonnement lumineux comporte des puits quantiques par exemple en InGaN.

Dans le cas où les diodes sont de type organique (OLED), les portions conductrices inférieure 31 et supérieure 33 peuvent être respectivement, par exemple, des portions de transport de trous (HTL) et des portions de transport d'électrons (ETL).

Les portions 31, 32 et 33 des diodes sont ici distinctes d'une diode à l'autre. Elles sont coplanaires, dans le sens où les portions 31 des diodes sont coplanaires entre elles, les portions 32 sont coplanaires entre elles, et les portions 33 sont coplanaires entre elles. La face supérieure de la portion 33 et la face inférieure de la portion 31 sont planes et parallèles entre elles.

Par ailleurs, la portion conductrice inférieure 31 est ici réalisée en un ou plusieurs matériaux semiconducteurs (ici du p-GaN). Cependant, comme décrit plus bas en référence à la fig.2B, la portion conductrice inférieure 31 peut être formée d'une portion semiconductrice 31.1 (située du côté de la portion active 32) et d'une portion conductrice 31.2 sous-jacente (située du côté de la portion réflectrice 22). La portion conductrice 31.2 permet d'ajuster la distance entre les portions actives 32 et les portions réflectrices 22 sous-jacentes (distance h_{sc} dans les pixels lumineux sans conversion Px_{sc}, et distance h_{ac} dans les pixels lumineux à conversion Px_{ac}).

Les diodes électroluminescentes comportent des électrodes inférieures réflectrices 21, 22, en contact électrique avec les portions conductrices inférieures 31. Elles sont formées d'une portion de contact 21 et d'une portion réflectrice 22. La portion de contact 21 peut être réalisée en un ou plusieurs matériaux comme par exemple le Ti, le Ni, le Pt, le Sn, l'Au, l'Ag, l'Al, le Pd, le W, le Pb, le Cu, l'AuSn, le TiSn ou un alliage de ces éléments. Il peut ainsi s'agir d'un empilement de sous-couches de Ti et TiN. La portion de contact 22 est réalisée en au moins un matériau réfléchissant la lumière émise par la portion active, par exemple en aluminium ou l'argent.

Dans cet exemple, les portions de contact 21 et les portions réflectrices 22 sont distinctes d'une diode à l'autre. Autrement dit, les portions de contact 21 sont physiquement séparées d'une diode à l'autre, comme le sont les portions réflectrices 22. Cependant, comme l'illustre la fig.2B, les portions de contact 21 peuvent être continûment jointives de manière à former une même couche. C'est le cas également de la portion réflectrice 22.

La portion réflectrice 22 est réalisée en le ou les mêmes matériaux d'une diode à l'autre et présente une même épaisseur. La portion de contact 21 est réalisée en le ou les mêmes matériaux d'une diode à l'autre, mais présente une épaisseur différente entre son épaisseur dans les pixels lumineux à conversion Px_{ac} et son épaisseur dans les pixels lumineux sans conversion Px_{sc}, de sorte que la face inférieure des portions de contact 21 est coplanaire d'une portion de contact à l'autre.

Notons que les diodes sont séparées les unes des autres dans le plan XY par un ou des matériaux de pixellisation. Il peut être formé d'une première fine couche de passivation isolante, puis d'une deuxième fine couche réflectrice, par exemple une fine couche d'aluminium ou d'argent, de manière à limiter la diaphonie optique (*crosstalk* en anglais) entre les diodes, et d'un matériau de remplissage qui remplit l'espace restant entre les diodes. D'autres configurations sont possibles.

Par ailleurs, les flancs des diodes sont ici verticaux, mais, en variante, peuvent être inclinés avec un angle par exemple compris entre -30° et +30° par rapport à l'axe Z, et de préférence compris entre -10° et +10°. Le choix de l'angle d'inclinaison des flancs peut participer à améliorer le taux de couplage de la lumière dans les portions de conversion 40.

Les diodes électroluminescentes comportent ici des électrodes supérieures transparentes 24 qui recouvrent entièrement la portion sous-jacente 33. Elles sont réalisées en au moins un matériau électriquement conducteur et transparent au rayonnement lumineux émis par les portions actives 32. Elles peuvent être en un TCO, comme par exemple en ITO (oxyde d'indium étain), voire en un ou des matériaux métalliques fins semi-transparents (par ex. Ag). Dans cet exemple, les électrodes 24 sont distinctes d'une diode à l'autre.

La puce optoélectronique 20 comporte des portions de conversion de lumière 40, distinctes les unes des autres (physiquement séparées deux à deux, par exemple par de l'air), et disposées en regard de certaines diodes de la matrice de manière à former des pixels lumineux à conversion de couleur Px_{ac}. Ces portions de conversion 40 sont adaptées à convertir au moins en partie un rayonnement lumineux incident d'une première longueur d'onde λ₁ en un rayonnement lumineux de luminescence de plus grande longueur d'onde λ₂. A titre illustratif, elles peuvent être adaptées à absorber de la lumière bleue, c'est-à-dire dont la longueur d'onde est comprise entre 440nm et 490nm environ, et à émettre dans le vert, c'est-à-dire à une longueur d'onde comprise entre 495nm et 560nm environ, voire dans le rouge, c'est-à-dire à une longueur d'onde comprise entre 600nm et 650nm. Par longueur d'onde, on entend ici la longueur d'onde à laquelle le spectre d'émission présente un pic d'intensité.

Les portions de conversion 40 comportent des particules photoluminescentes qui peuvent être formées d'au moins un composé semiconducteur, qui peut être choisi, par exemple, parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. Les nanoparticules peuvent également présenter une structure de type cœur/coquille, telle que CdSe/ZnS, CdSe/CdS, CdSe/CdS/ZnS, PbSe/PbS, CdTe/CdSe, CdSe/ZnTe, InP/ZnS ou autre. Les particules peuvent également présenter une structure cristalline pérovskite comportant des atomes tels que ceux listés pour les nanoparticules mais également Cs, Mn, Br. Les portions de conversion 40 peuvent présenter une épaisseur comprise entre 100nm et 10µm, par exemple de l'ordre de 2µm. Comme indiqué précédemment, la bordure latérale des portions de conversion 40 peut être recouverte par une fine couche réflectrice, de manière à orienter le rayonnement suivant la direction +Z.

Selon l'invention, les diodes électroluminescentes sont dimensionnées de sorte que, dans les pixels lumineux sans conversion de couleur Px_{sc}, la portion active 32 est espacée de la portion réflectrice 22 d'une distance optimale h_{sc.opt} prédéfinie qui maximise l'extraction de la lumière hors de la diode électroluminescente. De plus, dans les pixels lumineux à conversion de couleur Px_{ac}, la portion active 32 est espacée de la portion réflectrice 22 d'une distance optimale h_{ac.opt} prédéfinie qui maximise le couplage de la lumière émise par la portion active 32 avec des modes optiques supportés par la portion de conversion 40.

Pour cela, on réalise des portions conductrices inférieures 31 ayant une même épaisseur optimale e_{31.opt} dans les pixels lumineux sans conversion de couleur Px_{sc} et les pixels lumineux à conversion de couleur Px_{ac} ; et on place des portions espaceur 23 d'épaisseur optimale e_{23.opt}, soit dans les pixels lumineux sans conversion de couleur Px_{sc} uniquement (premier mode de réalisation), soit dans les pixels lumineux à conversion de couleur Px_{ac} uniquement (deuxième mode de réalisation).

Par modes optiques supportés par la portion de conversion 40, on entend des modes optiques circulant dans la structure diode 30 et dans la portion de conversion 40, et dont la fraction de puissance optique est notée f_{p1.ac}. Il s'agit de modes optiques qui peuvent être extraits hors de la diode (ici dans l'air) et dont la fraction de puissance est notée f_{p1.ac.e}, et de modes optiques qui sont piégés et ne peuvent être extraits hors de la diode et dont la fraction de puissance est notée f_{p1.ac.p}. Quoi qu'il en soit, les modes optiques se propagent dans la portion de conversion 40, et peuvent y être absorbés par les particules photoluminescentes, ce qui améliore le taux de conversion. Le taux de conversion est défini ici comme le rapport de l'intensité du rayonnement de photoluminescence émis par les particules photoluminescentes de la portion de conversion 40 sur l'intensité du rayonnement d'électroluminescence émis par la portion active 32.

Les portions espaceur 23 sont réalisées en au moins un matériau électriquement conducteur et transparent à la longueur d'onde de la diode. Elle peut présenter le même indice de réfraction que celui de la portion conductrice inférieure 31. Il peut s'agir d'un oxyde transparent conducteur, tel qu'un oxyde métallique conducteur (ITO, ZnO, AZO...). Dans le cas d'une OLED, le matériau peut être un matériau organique permettant le transport des trous ou électrons. Elles sont situées entre la portion réflectrice 22 et la portion conductrice inférieure 31 des pixels lumineux à conversion Px_{ac} uniquement (premier mode de réalisation) ou des pixels lumineux sans conversion Px_{sc} uniquement (deuxième mode de réalisation).

Les distances h_{sc} et h_{ac} sont définies comme étant la distance suivant l'axe Z entre, d'une part, un plan supérieur passant dans la portion active 32 où se situe l'essentiel des recombinaisons radiatives des paires électron-trou, et d'autre part la face supérieure de la portion réflectrice 22. Le plan supérieur peut passer au milieu de la portion active 32. En variante, dans le cas comme ici où la portion active 32 présente une épaisseur négligeable, on peut considérer que le plan supérieur passe à l'interface entre la portion active 32 et la portion conductrice inférieure 31.

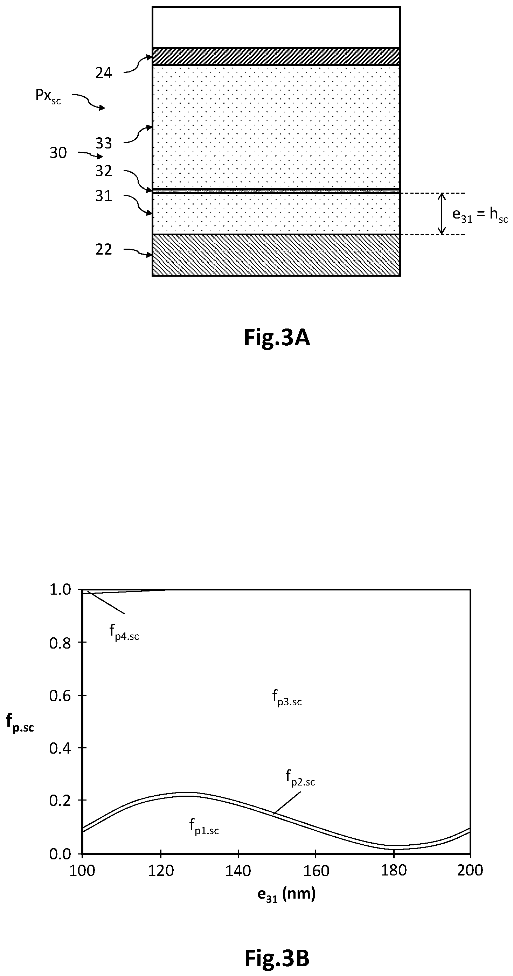

On décrit maintenant, en référence aux figures 3A et 3B, une étape de détermination de la distance optimale h_{sc.opt}, et plus précisément de l'épaisseur optimale e_{31.opt}, pour les pour les pixels lumineux sans conversion Px_{sc} d'un dispositif optoélectronique 1 similaire à celui de la fig.2A, donc selon le premier mode de réalisation où les portions espaceur 23 sont situées uniquement dans les pixels lumineux à conversion de couleur Px_{ac}.

La fig.3A est une vue schématique et partielle, en coupe transversale, d'un diode d'un pixel lumineux sans conversion Px_{sc} d'un dispositif optoélectronique 1 similaire à celui de la fig.2A.

Le pixel lumineux sans conversion Px_{sc} est formé de : une portion réflectrice 22, ici en aluminium d'une épaisseur infinie ; une structure diode 30 formée d'une portion semiconductrice inférieure 31 en GaN dopé de type p et d'une épaisseur e₃₁, d'une portion active (non représentée, épaisseur négligeable), et d'une portion semiconductrice supérieure 33 réalisée en GaN dopée de type n et d'une épaisseur de 400nm. Enfin, une électrode transparente 24 en ITO et d'une épaisseur de 40nm recouvre la portion supérieure 33. L'environnement de la diode est de l'air. Les flancs sont recouverts d'une fine couche réflectrice (non représentée) pour limiter la diaphonie optique.

La fig.3B illustre une variation, en fonction de l'épaisseur e₃₁ de la portion conductrice inférieure 31, de la répartition de la puissance f_{p.sc} du rayonnement émis par la portion active 32 de la diode et dissipé dans différents modes optiques associés au pixel lumineux Px_{sc}.

Rappelons que l'efficacité quantique externe (ou rendement lumineux, noté EQE ou ηₑₓₜ) correspond au rapport du flux lumineux émis par la portion active sur la puissance électrique injectée. Elle est égale au produit du rendement quantique interne (IQE ou ηᵢₙₜ) et de l'efficacité d'extraction (ηₒᵤₜ). Cette efficacité d'extraction ηₒᵤₜ dépend en particulier de la répartition de la puissance du rayonnement émis par la portion active de la diode et dissipé dans différents modes optiques associés au pixel lumineux. On peut distinguer plusieurs modes optiques : ceux extraits hors de la diode (fraction de la puissance f_{p1.sc}), ici dans l'air ; ceux absorbés dans la diode (fraction de la puissance f_{p2.sc}) ; ceux guidés dans la diode (fraction de la puissance f_{p3.sc}) ; et enfin ceux couplés par évanescence et absorbés dans ou à l'interface de l'électrode inférieure (fraction de la puissance f_{p4.sc}).

Cette variation de la répartition de la puissance dissipée en fonction de l'épaisseur e₃₁ de la portion semiconductrice inférieure 31 peut être calculée par résolution numérique des équations de Maxwell. On obtient ainsi une fonction exprimant une évolution du paramètre f_{p1.sc} représentatif du taux d'extraction, en fonction de l'épaisseur e₃₁ de la portion inférieure conductrice 31, dans les pixels lumineux sans conversion Px_{sc}. On peut faire référence ici notamment à l'article de Benisty et al. intitulé Impact of planar microcavity effects on light extraction - Part I : Basic concepts and analytical trends, IEEE J. Quantum Electron., vol.34, no.9, pp.1612-1631, 1998, ainsi qu'à l'article de Schmidt et al. intitulé Emitter Orientation as a Key Parameter in Organic Light-Emitting Diodes, Phys. Rev. Applied 8, 037001 (2017).

Cette répartition de la puissance dissipée dépend des indices de réfraction et des épaisseurs des portions de la diode, de la distance h_{sc} et de l'orientation considérée du dipôle émetteur. Rappelons ici que le rayonnement lumineux émis dans la portion active par recombinaison radiative des paires électron-trou correspond au rayonnement dipolaire électrique émis par un dipôle qui oscille de manière harmonique suivant l'axe de son moment dipolaire µ (également appelé TDMV, pour *Transition Dipole Moment Vector,* en anglais). On considère ici que le dipôle est orienté horizontalement (ici parallèle au plan principal de la puce optoélectronique).

Nous nous intéressons ici à la fraction f_{p1.sc} de la puissance optique qui est extraite hors de la diode, donc ici dans l'air. On choisit la valeur optimale e_{31.opt} de l'épaisseur e₃₁ qui permet de maximiser cette fraction de puissance f_{p1.sc}. Dans cet exemple, l'épaisseur optimale e_{31.opt} est de l'ordre de 125nm. Ainsi, dans la matrice de diodes, toutes les portions conductrices inférieures 31 présentent la même épaisseur e_{31.opt} de 125nm. Ainsi, les pixels lumineux sans conversion Px_{sc} présentent un taux d'extraction maximisé.

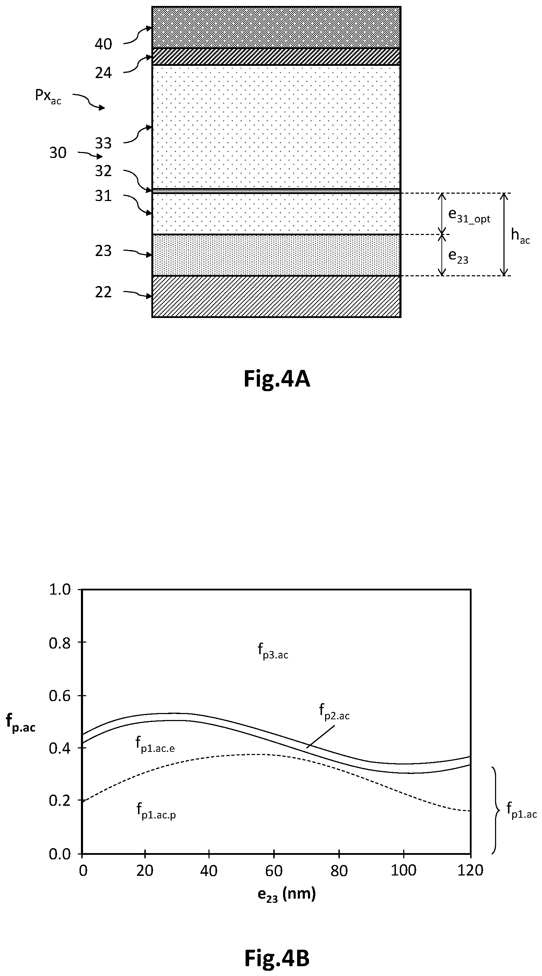

On décrit maintenant, en référence aux figures 4A et 4B, une étape de détermination de la distance optimale h_{ac.opt} pour les pixels lumineux à conversion Px_{ac} du dispositif optoélectronique 1 similaire à celui de la fig.2A.

La fig.4A est une vue schématique et partielle, en coupe transversale, d'une diode d'un pixel lumineux à conversion Px_{ac} du dispositif optoélectronique 1 similaire à celui de la fig.2A.

Le pixel lumineux à conversion Px_{ac} présente la structure d'empilement similaire à celle du pixel de la fig.3A, et s'en distingue par la présence d'une portion espaceur 23 en ITO située entre la portion réflectrice 22 et la portion semiconductrice inférieure 31. Il s'en distingue également par la présence d'une portion de conversion 40 qui recouvre entièrement la face supérieure de l'électrode supérieure transparente 24. Par ailleurs, la portion semiconductrice inférieure 31 présente l'épaisseur optimale e_{31.opt} de 125nm déterminée lors de l'étape précédente.

La fig.4B illustre une variation, en fonction de l'épaisseur e₂₃ de la portion espaceur 23, de la répartition de la puissance f_{p.ac} du rayonnement émis par la portion active 32 de la diode et dissipé dans différents modes optiques associés au pixel lumineux Px_{ac}.

Ici, la fraction de puissance f_{p1.ac} correspond à la puissance optique dissipée dans des modes optiques supportés par la structure diode 30 et par la portion de conversion 40. Cette fraction de puissance f_{p1.ac} comporte deux composantes : d'une part, une première partie f_{p1.ac.e} qui contient les modes optiques pouvant se propager dans l'air ; et d'autre part, une deuxième partie f_{p1.ac.p} qui ne contient pas les modes optiques pouvant se coupler dans l'air pour cause de réflexion totale interne entre la portion de conversion 40 et l'air : elle porte donc sur les modes optiques supportés et piégés dans la structure diode 30 et la portion de conversion 40.

Autrement dit, la première composante f_{p1.ac.e} correspond à toute lumière émise par la portion active 32 pouvant se propager dans la couche de conversion 40, cette lumière pouvant être transmise dans l'air après avoir traversé la couche de conversion 40. Quant à la deuxième composante f_{p1.ac.p}, elle correspond à de la lumière émise par la portion active 32 et pouvant se propager dans la couche de conversion 40 mais ne permettant pas la propagation dans l'air : la lumière est alors piégée dans la structure diode 30 et dans la portion de conversion 40 par réflexion totale interne.

Plusieurs stratégies sont possibles pour maximiser le couplage de la lumière avec les portions de conversion 40.

Ainsi, dans le cas où la portion de conversion 40 est épaisse, par exemple au moins égale à 5µm, on peut choisir la valeur optimale e_{23.opt} de l'épaisseur e₂₃ des portions espaceur 23 qui maximise la fraction de puissance f_{P1.ac}. En effet, les modes optiques qui circulent dans la portion de conversion 40 pourront y être absorbés et convertis, qu'il s'agisse des modes optiques qui pourront être extraits dans l'air (fraction f_{p1.ac.e}) comme des modes optiques piégés (fraction f_{p1.ac.p}). Dans cet exemple, l'épaisseur optimale e_{23.opt} pourra être choisie égale à 20nm environ.

En variante, dans le cas où la portion de conversion 40 est mince, par exemple au plus égale à 4µm, on peut choisir la valeur optimale e_{23.opt} de l'épaisseur e₂₃ des portions espaceur 23 qui maximise la fraction de puissance f_{P1.ac.p}. En effet, on privilégiera les modes optiques qui circulent et sont piégés dans la structure diode 30 et la portion de conversion 40. On améliore ainsi les chances d'absorption et donc le taux de conversion. Dans cet exemple, l'épaisseur optimale e_{23.opt} pourra être choisie égale à 45-50nm environ.

Par ailleurs, on peut chercher à maximiser le taux de conversion (donc à maximiser la fraction f_{p1.ac} ou la fraction f_{p1.ac.p}) tout en minimisant également le flux de la lumière émise par la portion active 32 et pas ou peu absorbée par la portion de conversion 40 (donc à minimiser la fraction f_{p1.ac.e}). Cela permet notamment d'éviter d'avoir à utiliser un filtre bleu (dans le cas où la portion active 32 émet dans le bleu) dans les pixels lumineux à conversion Px_{ac}. C'est particulièrement avantageux lorsque la portion de conversion 40 est mince (donc lorsqu'on maximise la fraction f_{p1.ac.p}). Dans cet exemple, l'épaisseur optimale e_{23.opt} pourra être choisie égale à 75-80nm environ, ce qui permet de maximiser la fraction f_{p1.ac.p} et de minimiser la fraction f_{p1.ac.e}.

Ainsi, le dispositif optoélectronique 1 selon le premier mode de réalisation présente des performances améliorées, par le fait que le dimensionnement des diodes électroluminescentes, en termes d'épaisseur e₃₁ de la portion conductrice inférieure 31 et d'épaisseur e₂₃ de la portion espaceur 23 (et donc en termes de distances h_{sc} et h_{ac}), permet à la fois de maximiser le taux d'extraction dans les pixels lumineux sans conversion Px_{sc} et le taux d'absorption (et donc le taux de conversion) dans les portions de conversion 40 des pixels lumineux à conversion Px_{ac}. Cela permet notamment d'éviter d'avoir à réaliser des portions de conversion de trop grande épaisseur, et cela permet également de développer des dispositifs optoélectroniques à faible pas pixel.

De plus, comme les portions conductrices inférieures 31 présentent la même épaisseur e_{31.opt} et que la distance h_{ac} est ajustée via l'épaisseur e₂₃ des portions espaceur 23, on évite ainsi d'avoir à modifier localement l'épaisseur e₃₁ des portions conductrices inférieures 31, ce qui pourrait se traduire par une dégradation du rendement quantique interne (IQE). On évite également les problématiques de conductivité du GaN dopé de type p.

Par ailleurs, comme indiqué précédemment, il est également possible de limiter, dans les pixels lumineux à conversion Px_{ac}, le flux de lumière émis par la portion active 32 et non absorbé par la portion de conversion 40. Cela permet d'éviter d'avoir à disposer un filtre de la lumière émise par les diodes (par exemple ici un filtre bleu) dans les pixels lumineux à conversion Px_{ac}.

Ainsi, un procédé de fabrication d'un dispositif optoélectronique selon le premier mode de réalisation (où les portions espaceur 23 sont situées uniquement dans les pixels lumineux à conversion Px_{ac}), peut comporter les étapes suivantes :
- détermination, pour les pixels lumineux sans conversion Px_{sc}, d'une épaisseur optimale e_{31.opt} des portions conductrices inférieures 31, à partir d'une fonction prédéterminée exprimant une évolution du paramètre (fraction f_{p1.sc}) représentatif du taux d'extraction en fonction de l'épaisseur e₃₁ de la portion inférieure conductrice 31, l'épaisseur optimale e_{31.opt} maximisant le paramètre f_{p1.sc} ; on obtient ainsi la distance h_{sc.opt} ;
- détermination, pour les pixels lumineux à conversion Px_{ac} où les portions conductrices inférieures 31 présentent l'épaisseur optimale e_{31.opt} déterminée, d'une épaisseur optimale e_{23.opt} des portions espaceur 23, à partir d'une fonction prédéterminée exprimant une évolution du paramètre (fraction f_{p1.ac} ou fraction f_{p1.ac.p}) représentatif du taux de couplage, en fonction de l'épaisseur e₂₃ de la portion espaceur 23, l'épaisseur optimale e_{23.opt} maximisant le paramètre représentatif du taux de couplage ; on obtient ainsi la distance h_{ac.opt} ;
- réalisation de la matrice de diodes électroluminescentes, de sorte que : les portions conductrices inférieures 31 de la matrice de diodes (donc des pixels lumineux sans conversion Px_{sc} comme des pixels lumineux à conversion Px_{ac}) présentent la même épaisseur optimale e_{31.opt} déterminée; et les portions espaceur 23 (situées uniquement dans les pixels lumineux à conversion Px_{ac}) présentent la même épaisseur optimale e_{23.opt} déterminée.

La figure 2B est une vue schématique et partielle, en coupe transversale, d'un dispositif optoélectronique 1 selon un exemple du deuxième mode de réalisation.

Le dispositif optoélectronique 1 se distingue de celui de la fig.2A essentiellement en ce que les portions espaceur 23 sont disposés dans les pixels lumineux sans conversion Px_{sc} uniquement, et non pas dans les pixels lumineux à conversion Px_{ac}.

Par ailleurs, dans cet exemple, les portions de contact 21 et les portions réflectrices 22 forment l'une et l'autre des couches continues d'une diode à l'autre, mais elles pourraient être discontinues comme sur la fig.2A. Les électrodes inférieures sont donc toutes portées à un même potentiel électrique, et les diodes peuvent être activées de manière sélective en polarisant les électrodes supérieures indépendamment les unes des autres.

De plus, dans cet exemple, la couche conductrice inférieure 31 est formée d'une sous-couche 31.1 en un matériau semiconducteur, ici du p-GaN, et d'une sous-couche espaceur 31.2 en un matériau électriquement conducteur et transparent à la lumière émise par la couche active 32, par exemple ici un TCO comme de l'ITO.

On décrit maintenant une étape de détermination de la distance optimale h_{ac.opt}, et plus précisément de l'épaisseur optimale e_{31.opt}, pour les pour les pixels lumineux à conversion Px_{ac} d'un dispositif optoélectronique 1 similaire à celui de la fig.2B, donc selon le deuxième mode de réalisation où les portions espaceur 23 sont situées uniquement dans les pixels lumineux sans conversion de couleur Px_{sc}.

Tout d'abord, on considère un pixel lumineux à conversion Px_{ac}, et on détermine une variation, en fonction de l'épaisseur e₃₁ de la portion conductrice inférieure 31, de la répartition de la puissance f_{p.ac} du rayonnement émis par la portion active 32 de la diode et dissipé dans différents modes optiques associés au pixel lumineux Px_{ac}.

Nous nous intéressons ici à la puissance optique dissipée dans des modes optiques supportés par la portion de conversion 40 (et par la structure diode 30). On choisit la valeur optimale e_{31.opt} de l'épaisseur e₃₁ qui permet de maximiser le couplage avec la portion de conversion 40 (et donc le taux de conversion). Comme indiqué précédemment, on peut choisir l'épaisseur optimale e_{31.opt} qui maximise la fraction f_{p1.ac} (si la portion de conversion 40 est épaisse) ou la fraction f_{p1.ac.p} (si la portion de conversion 40 est mince). On peut également chercher à minimiser la fraction f_{p1.ac.e} pour limiter le flux de lumière non absorbé dans la portion de conversion 40 et ainsi pouvoir se passer de filtre bleu.

Ensuite, on considère un pixel lumineux sans conversion Px_{sc} et on détermine une variation, en fonction de l'épaisseur e₂₃ de la portion espaceur 23, de la répartition de la puissance f_{p.sc} du rayonnement émis par la portion active 32 et dissipé dans différents modes optiques associés au pixel lumineux Px_{sc}. Ici, dans les pixels lumineux Px_{sc} et Px_{ac}, les portions conductrices inférieures 31 présentent l'épaisseur optimale e_{31.opt} qui vient d'être déterminée.

Nous nous intéressons maintenant à la puissance optique f_{p1.sc} extraite dans l'air. On choisit la valeur optimale e_{23.opt} de l'épaisseur e₂₃ qui permet de maximiser l'extraction de la lumière hors de la diode, et donc qui maximise la fraction f_{p1.sc}, en tenant compte de e_{31.opt}.

Ainsi, le dispositif optoélectronique 1 selon le deuxième mode de réalisation présente également des performances améliorées, par le fait que le dimensionnement des diodes électroluminescentes, en termes d'épaisseur e₃₁ de la portion conductrice inférieure 31 et d'épaisseur e₂₃ de la portion espaceur 23 (et donc en termes de distances h_{sc} et h_{ac}), permet ici aussi de maximiser le taux d'extraction dans les pixels lumineux sans conversion Px_{sc} et le taux d'absorption (et donc le taux de conversion) dans les portions de conversion 40 des pixels lumineux à conversion Px_{ac}.

Ainsi, un procédé de fabrication d'un dispositif optoélectronique selon le deuxième mode de réalisation (où les portions espaceur 23 sont situées uniquement dans les pixels lumineux sans conversion Px_{sc}), peut comporter les étapes suivantes :
- détermination, pour les pixels lumineux à conversion Px_{ac}, d'une épaisseur optimale e_{31.opt} des portions conductrices inférieures 31, à partir d'une fonction prédéterminée exprimant une évolution d'un paramètre (fraction f_{p1.ac} ou fraction f_{p1.ac.p}) représentatif du taux de couplage, en fonction de l'épaisseur e₃₁ de la portion inférieure conductrice 31, l'épaisseur optimale e_{31.opt} maximisant le paramètre représentatif du taux de couplage ; on obtient ainsi la distance h_{ac.opt} ;
- détermination, pour les pixels lumineux sans conversion Px_{ac} où les portions conductrices inférieures 31 présentent l'épaisseur optimale e_{31.opt} déterminée, d'une épaisseur optimale e_{23.opt} des portions espaceur 23, à partir d'une fonction prédéterminée exprimant une évolution du paramètre (fraction f_{p1.sc}) représentatif du taux d'extraction en fonction de f_{p1.sc} ; l'épaisseur optimale e_{23.opt} maximisant le paramètre f_{p1.sc} ; on obtient ainsi la distance h_{sc.opt} ;
- réalisation de la matrice de diodes électroluminescentes, de sorte que : les portions conductrices inférieures 31 de la matrice de diodes (donc des pixels lumineux sans conversion Px_{sc} comme des pixels lumineux à conversion Px_{ac}) présentent la même épaisseur optimale e_{31.opt} déterminée; et les portions espaceur 23 (situées uniquement dans les pixels lumineux sans conversion Px_{sc}) présentent la même épaisseur optimale e_{23.opt} déterminée.

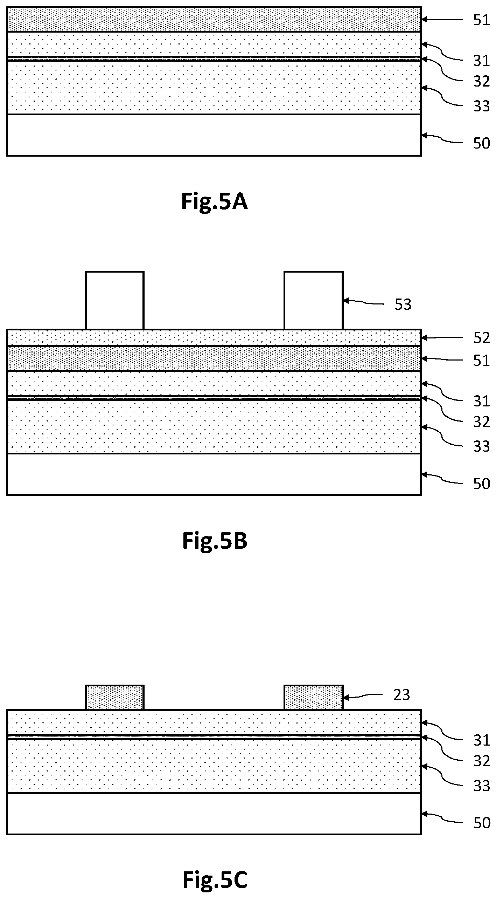

Les figures 5A à 5H illustrent des étapes d'un procédé de fabrication d'un dispositif optoélectronique 1 selon une variante du premier mode de réalisation, donc similaire à celui de la fig.2A mais qui en diffère en ce que les portions de contact 21 et réflectrices 22 forment des couches continues d'une diode à l'autre.

En référence à la fig.5A, on réalise par épitaxie, à partir d'un substrat de croissance 50 (ici un substrat de silicium et des couches tampon en AlGaN d'adaptation du paramètre de mail), un empilement semiconducteur formé d'une première couche 33 de GaN dopé de type n, d'une couche active 32 comportant des puits quantiques en InGaN, et d'une deuxième couche 31 de GaN dopé de type p. La couche 31 de p-GaN présente une épaisseur e_{31.opt}, ici de 125nm, de sorte que la distance h_{sc} présentera la valeur optimale h_{sc.opt}.

Puis on dépose une couche espaceur 51 de manière à recouvrir la face libre de la couche 31 de p-GaN. Elle présente une épaisseur e_{23.opt}, ici de 20nm ou de 45-50nm environ, de sorte que la distance h_{ac} présentera la valeur optimale prédéterminée h_{ac.opt}. Le matériau de la couche espaceur 51 (et donc des portions espaceur 23) est ici un oxyde conducteur transparent (TCO) tel que de l'ITO. Il présente en effet un bon contact électrique et une bonne adhérence sur le p-GaN, une bonne adhérence avec la couche réflectrice 22 déposée plus tard, et une bonne compatibilité de gravure.

En référence à la fig.5B, on dépose une couche d'oxyde 52, par exemple un TEOS d'une épaisseur de l'ordre de quelques centaines de nanomètres, de manière à recouvrir la face libre de la couche espaceur 51. Puis, on réalise des plots de masque 53 en vue de la réalisation des portions espaceur.

En référence à la fig.5C, on réalise les portions espaceur 23. Pour cela, on peut effectuer une première étape de gravure sèche (RIE) de la couche d'oxyde 52 (non protégée par les plots de masque 53) avec arrêt de gravure sur la couche espaceur 31. Puis, on effectue une étape de *stripping* de manière à enlever les plots de masque 33. Puis, on grave localement la couche espaceur 31 non protégée par les portions d'oxyde restant, par exemple par une gravure humide à l'acide chlorhydrique (HCl) avec arrêt de gravure sur la couche 31 de p-GaN. Enfin, on effectue une gravure de retrait des portions d'oxyde, par exemple par une gravure humide à l'acide fluorhydrique (HF). On obtient ainsi des portions espaceur 23 et la couche 31 de p-GaN présente une surface libre.

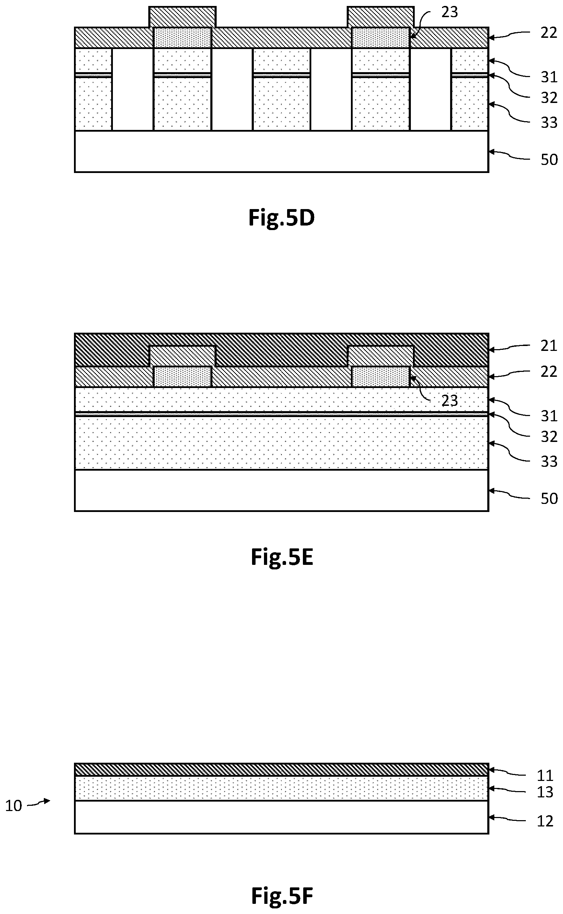

En référence à la fig.5D, on réalise la couche réflectrice 22, ici par dépôt d'une couche d'aluminium d'une épaisseur de 100nm. Cette couche 22 s'étend au contact de la surface libre de la couche 31 de p-GaN et recouvre les portions espaceur 23.

En référence à la fig.5E, on réalise ensuite la couche de contact 21. Celle-ci est déposée sur et au contact de la couche réflectrice 22. Il peut s'agir d'un empilement de plusieurs sous-couches, comme par exemple, une sous-couche d'adhérence de Ti de 10nm d'épaisseur, suivie d'une sous-couche barrière de TiN de 40nm d'épaisseur, et enfin d'une sous-couche de contact/collage de Ti de 500nm d'épaisseur. Une étape de polissage mécano-chimique (CMP) est ensuite effectuée de manière à rendre plane la face supérieure de la couche de contact 21.

En référence à la fig.5F, on réalise un substrat support 10 qui assure le support mécanique et la connexion électrique de la puce optoélectronique. Il peut former la puce de commande 10 mentionnée précédemment. Dans cet exemple, le substrat support 10 est formé d'un empilement d'une couche de silicium 12 (par exemple un wafer de silicium), d'une couche supérieure d'oxyde 13, et enfin d'une couche conductrice de contact 11. Celle-ci peut être formée d'un empilement d'une sous-couche de Ti de 5nm d'épaisseur, puis d'une sous-couche de TiN de 30nm d'épaisseur, et enfin d'une sous-couche de Ti d'une épaisseur de 100 à 200nm environ (après une étape de polissage mécano-chimique).

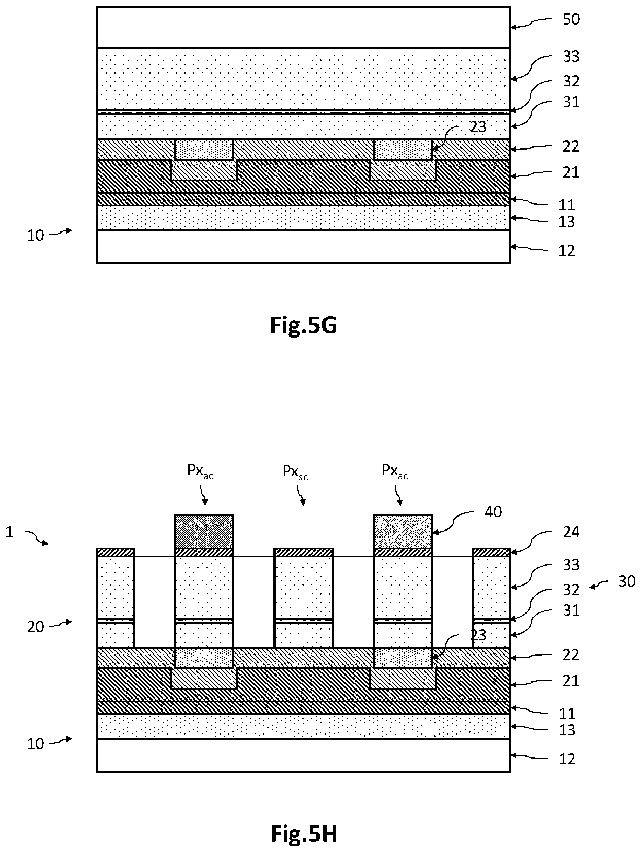

En référence à la fig.5G, on effectue un assemblage par report et collage direct Ti/Ti de la structure de la fig.5E sur le substrat support 10. Plus précisément, on met en contact les deux couches conductrices 11 et 21.

En référence à la fig.5H, on retire le substrat de croissance 50, par exemple par meulage (*grinding,* en anglais) suivi d'une gravure chimique, de manière à rendre libre la face supérieure de la couche 33 de n-GaN. On pixellise ensuite les diodes, puis on réalise les électrodes supérieures 24, ici en un matériau électriquement conducteur et transparent comme de l'ITO. Leur agencement définit les pixels lumineux. Enfin, on réalise les portions de conversion 40 au niveau des pixels lumineux à conversion Px_{ac}.

Ainsi, on obtient un dispositif optoélectronique 1 dont les pixels lumineux sans conversion Px_{sc} présentent un taux d'extraction maximisé par le dimensionnement de la distance h_{sc} et ici de l'épaisseur e₃₁ de la couche semiconductrice inférieure 31, et dont les pixels lumineux à conversion Px_{ac} présentent un taux de conversion maximisé par le dimensionnement de la distance h_{ac} et ici de l'épaisseur e₂₃ des portions espaceur 23 (compte tenu de l'épaisseur e_{31.opt} de la couche 31). Les performances du dispositif optoélectronique 1 sont donc optimisées.

Des modes de réalisation particuliers viennent d'être décrits. Différentes variantes et modifications apparaîtront à l'homme du métier.

## Revendications

1. Dispositif optoélectronique (1) à conversion de lumière, comportant :
∘ une matrice de diodes électroluminescentes, chaque diode électroluminescente comportant dans cet ordre : une électrode inférieure réflectrice formée d'une portion de contact (21) puis d'une portion réflectrice (22) ; une structure diode (30) formée d'une portion conductrice inférieure (31) d'une même épaisseur (e_{31.opt}) pour toutes les diodes de la matrice, d'une portion active (32) d'émission de lumière, puis d'une portion conductrice supérieure (33) ; et une électrode supérieure (24) ;
∘ des plots de conversion de couleur (40), recouvrant certaines diodes électroluminescentes de la matrice, et définissant des pixels lumineux à conversion de couleur (Px_{ac}) ; les diodes électroluminescentes non recouvertes par des plots de conversion (40) définissant des pixels lumineux sans conversion de couleur (Px_{sc}) ;
∘ **caractérisé en ce qu'**il comporte des portions espaceur (23), réalisées en un matériau électriquement conducteur et transparent à la lumière émise, et situées entre la portion réflectrice (22) et la portion conductrice inférieure (31) des pixels lumineux à conversion (Px_{ac}) uniquement ou des pixels lumineux sans conversion (Px_{sc}) uniquement ;
∘ et **en ce que** l'épaisseur (e_{31.opt}) des portions conductrices inférieures (31) et l'épaisseur (e_{23.opt}) des portions espaceur (23) étant prédéfinies de sorte que :
• chaque portion active (32) des pixels lumineux sans conversion (Px_{sc}) est espacée de la portion réflectrice (22) d'une même distance optimale h_{sc.opt} maximisant, dans les pixels lumineux sans conversion (Px_{sc}), un paramètre (f_{p1.sc}) représentatif d'un taux d'extraction de la lumière émise par la portion active (32) hors de la diode électroluminescente ; et
• chaque portion active (32) des pixels lumineux à conversion (Px_{ac}) est espacée de la portion réflectrice (22) d'une même distance optimale h_{ac.opt} maximisant, dans les pixels lumineux à conversion (Px_{ac}), un paramètre (f_{p1.ac} ; f_{p1.ac.p}) représentatif d'un taux de couplage de la lumière émise par la portion active (32) avec des modes optiques supportés dans la portion de conversion (40).

2. Dispositif optoélectronique (1) selon la revendication 1, dans lequel les portions réflectrices (22) de la matrice de diodes présentent une même épaisseur.

3. Dispositif optoélectronique (1) selon la revendication 1 ou 2, dans lequel les portions de contact (21) présentent une épaisseur différente entre les pixels lumineux à conversion (Px_{ac}) et les pixels lumineux sans conversion (Px_{sc}), et présentent une face inférieure coplanaire d'une portion de contact (21) à l'autre.

4. Dispositif optoélectronique (1) selon l'une quelconque des revendications 1 à 3, dans lequel les portions conductrices inférieures (31) présentent une face inférieure coplanaire d'une portion conductrice inférieure (31) à l'autre.

5. Dispositif optoélectronique (1) selon l'une quelconque des revendications 1 à 4, dans lequel les portions actives (32) sont coplanaires.

6. Dispositif optoélectronique (1) selon l'une quelconque des revendications 1 à 5, dans lequel la portion conductrice inférieure (31) est réalisée en au moins un matériau semiconducteur.

7. Dispositif optoélectronique (1) selon l'une quelconque des revendications 1 à 6, dans lequel la portion conductrice inférieure (31) comporte une première sous-couche (31.1) en au moins un matériau semiconducteur, située du côté de la portion active (32), et une deuxième sous-couche (31.2) en un matériau électriquement conducteur et transparent à la lumière émise, située du côté de la portion réflectrice (22).

8. Dispositif optoélectronique (1) selon l'une quelconque des revendications 1 à 7, dans lequel les diodes électroluminescentes sont inorganiques ou organiques.

9. Procédé de fabrication du dispositif optoélectronique (1) selon l'une quelconque des revendications précédentes, comportant les étapes suivantes :
∘ détermination d'une épaisseur optimale e_{31.opt} des portions conductrices inférieures (31), à partir d'une fonction prédéterminée exprimant :
• selon une première possibilité : une évolution du paramètre (f_{p1.sc}) représentatif du taux d'extraction, en fonction de l'épaisseur e₃₁ de la portion inférieure conductrice (31), dans les pixels lumineux sans conversion (Px_{sc}), la valeur optimale e_{31.opt} maximisant le paramètre représentatif du taux d'extraction, de sorte que l'on obtient la distance h_{sc.opt} ; ou
• selon une deuxième possibilité : une évolution du paramètre (f_{p1.ac} ; f_{p1.ac.p}) représentatif du taux de couplage de la lumière émise par la portion active (32) avec des modes optiques supportés dans la portion de conversion (40), dans les pixels lumineux à conversion (Px_{ac}), la valeur optimale e_{31.opt} maximisant le paramètre représentatif du taux de couplage, de sorte que l'on obtient la distance h_{ac.opt} ;
∘ détermination d'une épaisseur optimale e_{23.opt} des portions espaceur (23), compte tenu d'épaisseur optimale e_{31.opt} prédéterminée, à partir d'une fonction prédéterminée exprimant :
• selon la première possibilité : une évolution du paramètre (f_{p1.ac} ; f_{p1.ac.p}) représentatif du taux de couplage, en fonction de l'épaisseur e₂₃ de la portion espaceur (23), les portions espaceur (23) étant situées uniquement dans les pixels lumineux à conversion (Px_{ac}), l'épaisseur optimale e_{23.opt} maximisant le paramètre représentatif du taux de couplage, de sorte que l'on obtient la distance h_{ac.opt} ;
• selon la deuxième possibilité : une évolution du paramètre (f_{p1.sc}) représentatif du taux d'extraction, en fonction de l'épaisseur e₂₃ de la portion espaceur (23), les portions espaceur (23) étant situées uniquement dans les pixels lumineux sans conversion (Px_{sc}), l'épaisseur optimale e_{23.opt} maximisant le paramètre représentatif du taux d'extraction, de sorte que l'on obtient la distance h_{sc.opt} ;
∘ réalisation de la matrice de diodes électroluminescentes, de sorte que : les portions conductrices inférieures (31) de la matrice de diodes présentent la même épaisseur optimale e_{31.opt} déterminée; et les portions espaceur (23) présentent la même épaisseur optimale e_{23.opt} déterminée.

10. Procédé de fabrication selon la revendication 9, dans lequel :
∘ lors de l'étape de détermination de l'épaisseur optimale e_{31.opt} et selon la deuxième possibilité, la valeur optimale e_{31.opt} est déterminée de manière à maximiser le paramètre représentatif du taux de couplage et à minimiser un paramètre (f_{p1.ac.e}) représentatif d'un deuxième taux de couplage de la lumière émise par la portion active (32) avec des modes optiques supportés dans la portion de conversion (40) et pouvant être extraits hors de la diode ;
∘ lors de l'étape de détermination de l'épaisseur optimale e_{23.opt} et selon la première possibilité, la valeur optimale e_{23.opt} est déterminée de manière à maximiser le paramètre représentatif du taux de couplage et à minimiser un paramètre (f_{p1.ac.e}) représentatif d'un deuxième taux de couplage de la lumière émise par la portion active (32) avec des modes optiques supportés dans la portion de conversion (40) et pouvant être extraits hors de la diode.

11. Procédé de fabrication selon la revendication 9 ou 10, dans lequel l'étape de réalisation de la matrice de diodes comporte les étapes suivantes :
∘ réalisation d'un empilement formé des portions conductrices supérieures (33), des portions actives (32), et des portions conductrices inférieures (31) ayant l'épaisseur optimale e_{31.opt} ;
∘ réalisation des portions espaceur (23), ayant l'épaisseur optimale e_{23.opt}, sur les portions conductrices inférieures (31) des pixels lumineux à conversion (Px_{ac}) dans la première possibilité ou dans les pixels lumineux sans conversion (Px_{sc}) selon la deuxième possibilité ;
∘ réalisation des portions réflectrices (22) puis des portions de contact (21).

12. Procédé de fabrication selon la revendication 11, comportant les étapes suivantes :
∘ à la suite de l'étape de réalisation de la matrice de diodes, report de la structure obtenue sur une puce de commande (10) ;
∘ réalisation des électrodes supérieures (24) sur les portions conductrices supérieures (33) ;
∘ réalisation des portions de conversion (40).
